# EUROPEAN PATENT APPLICATION

(11) **EP 4 550 409 A1**
(43) Date of publication of application: **07.05.2025**
(21) Application number: 23830908.2
(22) Date of filing: 25.05.2023
(51) Int. Cl.: H01L 23/473, H05K 7/20

(54) **UNIT**

(30) Priority: 28.06.2022 JP 2022103296
(71) Applicant: Jatco Ltd, Fuji-shi, Shizuoka 417-8585 (JP)
(72) Inventor: HAGIMORI, Hisaya, Fuji-shi, Shizuoka 417-8585 (JP); ISHII, Shigeru, Fuji-shi, Shizuoka 417-8585 (JP)
(74) Representative: Hoefer & Partner Patentanwälte mbB
(86) International application number: PCT/JP2023/019452
(87) International publication number: WO 2024/004457

(57) **Abstract**

[PROBLEM] To provide a structure in which a usage form of a fiber body based on a technical idea of performing cooling using an effect of turbulence is reflected.

[SOLUTION] A unit includes a cooling liquid, an electric circuit unit, and a heat conductive fiber body. The heat conductive fiber body includes a contact portion that is in contact with the electric circuit unit, and a bending portion that is bent. The bending portion is disposed in a liquid flow path of the cooling liquid.

## Description

### TECHNICAL FIELD

The present invention relates to a unit.

### BACKGROUND ART

Patent Document 1 discloses a cooling member in which a metal fiber sheet is accommodated in an accommodating body in contact with a heating element, and heat conducted from the heating element to the metal fiber sheet is taken by a refrigerant introduced into the accommodating body. Since the metal fiber sheet is made of copper fiber or aluminum fiber having high thermal conductivity, the metal fiber sheet is efficiently cooled by the refrigerant.

### PRIOR ART DOCUMENT

### PATENT DOCUMENT

Patent Document 1: JP2019-9433A

### SUMMARY OF INVENTION

### PROBLEMS TO BE SOLVED BY THE INVENTION

As a result of diligent studies, the present inventors have found that when a cooling liquid passes through fibers, turbulence occurs, and cooling is promoted by an effect of the turbulence. Furthermore, it has been found that when the cooling liquid passes through a surface of the fibers, turbulence is generated due to disorder of the surface of the fibers, and the cooling is promoted by an effect of the turbulence.

It means that cooling performance can be enhanced regardless of a material of a fiber body, and means that a fiber body can be used for cooling by a technical idea completely different from the technical idea described in Patent Document 1, that is, the technical idea of performing cooling by using the thermal conductivity of the metal fiber sheet. For this reason, it is desired to provide a unit having a new structure reflecting a usage form of a fiber body based on the technical idea of performing cooling using an effect of turbulence.

The present invention has been made in view of such a problem, and an object of the present invention is to provide a structure in which a usage form of a fiber body based on a technical idea of performing cooling using an effect of turbulence is reflected.

### SOLUTIONS TO THE PROBLEMS

A unit according to one aspect of the present invention includes a cooling liquid, an electric circuit unit, and a heat conductive fiber body. The heat conductive fiber body includes a contact portion that is in contact with the electric circuit unit, and a bending portion that is bent. The bending portion is disposed in a liquid flow path of the cooling liquid.

### ADVANTAGEOUS EFFECTS OF THE INVENTION

According to this aspect, by disposing the bending portion in the liquid flow path, turbulence occurs, and as a result, cooling of the bending portion itself is promoted. The bending portion is thermally connected to the electric circuit unit via the contact portion. Therefore, by releasing heat from the electric circuit unit to the cooling liquid through the bending portion, the electric circuit unit can be cooled by utilizing an effect of the turbulence, and cooling efficiency of the electric circuit unit can be further improved. According to such a structure of the heat conductive fiber body, length and flexibility can be appropriately adjusted, and therefore, a cooling flow path may be formed in any position, which contributes to an improvement in a degree of layout freedom of the entire unit.

### BRIEF DESCRIPTION OF DRAWINGS

[FIG. 1] FIG. 1 is a schematic configuration diagram of a unit according to the present embodiment.
[FIG. 2] FIG. 2 is a cross-sectional view showing a main part of an inverter.
[FIG. 3] FIG. 3 is an enlarged cross-sectional view of a bending portion and a partial path.
[FIG. 4] FIG. 4 is a diagram illustrating a bending direction of the bending portion.

### DESCRIPTION OF EMBODIMENTS

Hereinafter, an embodiment of the present invention will be described with reference to the accompanying drawings.

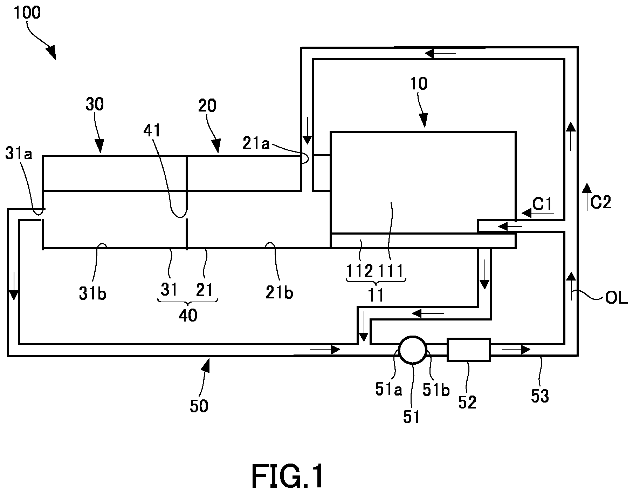

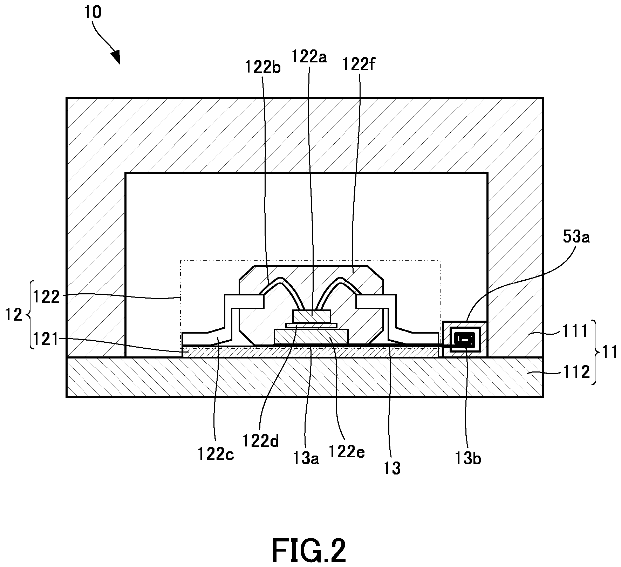

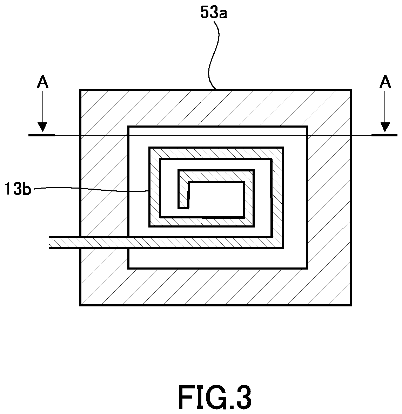

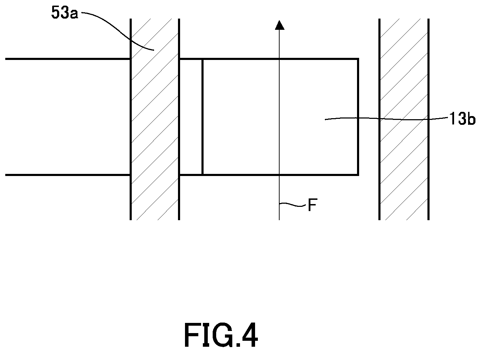

FIG. 1 is a schematic configuration diagram of a unit 100 according to the present embodiment. FIG. 2 is a cross-sectional view of a main part of an inverter 10. FIG. 3 is an enlarged cross-sectional view of a bending portion 13b and a partial path 53a. FIG. 4 is a diagram illustrating a bending direction of the bending portion 13b with respect to a liquid flow direction F in a cross section cut along a line A-A shown in FIG. 3. In FIG. 1, regarding a rotary electric machine 20 and a speed reducer 30, a rotor and a stator of the rotary electric machine 20, a speed reduction gear mechanism of the speed reducer 30, and the like are not shown, and an oil reservoir 21b of the rotary electric machine 20 and an oil reservoir 31b of the speed reducer 30 are schematically shown in the cross section.

The unit 100 is mounted on, for example, an electric vehicle driven by the rotary electric machine 20. The unit 100 includes the inverter 10, the rotary electric machine 20, the speed reducer 30, and a cooling device 50. The inverter 10 is an electric circuit unit and includes a case 11 and an electric circuit 12. The case 11 is an accommodating body and accommodates the electric circuit 12. The case 11 is made of, for example, an aluminum alloy. The case 11 may include a portion made of resin, for example. The case 11 includes a box-shaped portion 111 and a plate-shaped portion 112. The box-shaped portion 111 has a box shape with one surface opened, and the plate-shaped portion 112 closes the opening of the box-shaped portion 111. The case 11 is provided such that the plate-shaped portion 112 forms a lower surface in a gravity direction.

The electric circuit 12 is provided in the case 11. The electric circuit 12 includes a board 121 and a circuit portion 122. In FIG. 2, the circuit portion 122 is surrounded by a two-dot chain line. The board 121 is a printed circuit board and is disposed on a bottom wall of the case 11. The circuit portion 122 is mounted on the board 121. The circuit portion 122 is electrically connected to the board 121 by being connected to a circuit pattern of the board 121.

The circuit portion 122 includes a semiconductor element 122a, a wire 122b, a lead frame 122c, a bonding member 122d, a heat dissipation member 122e, and a mold resin 122f. The semiconductor element 122a is, for example, a power element, and is used as a switching element for an IGBT, a power MOSFET, or the like. A plurality of the semiconductor elements 122a can be provided, and for example, are arranged along a front-back direction of FIG. 2 (a direction orthogonal to a paper surface of FIG. 2). The semiconductor element 122a is electrically connected to the lead frame 122c via the wire 122b.

The bonding member 122d bonds the semiconductor element 122a to the heat dissipation member 122e, and the heat dissipation member 122e is used for heat dissipation of the semiconductor element 122a. The bonding member 122d and the heat dissipation member 122e are both heat conductive members, and heat of the semiconductor element 122a is transferred to the heat dissipation member 122e via the bonding member 122d. The bonding member 122d and the heat dissipation member 122e are members having a higher thermal conductivity than the mold resin 122f, for example.

The semiconductor element 122a is provided in the mold resin 122f and sealed by the mold resin 122f. Heat dissipation from the semiconductor element 122a is performed via, for example, the mold resin 122f. On the other hand, the lead frame 122c protrudes from the mold resin 122f, and the heat dissipation member 122e is exposed from the mold resin 122f. Therefore, the heat dissipation from the semiconductor element 122a can be promoted via the lead frame 122c and the heat dissipation member 122e. The lead frame 122c and the heat dissipation member 122e constitute a heat dissipation promoting unit that promotes the heat dissipation from the semiconductor element 122a to an outside of the mold resin 122f.

The rotary electric machine 20 is controlled by the inverter 10 to generate power. The power generated by the rotary electric machine 20 is transmitted to driving wheels of a vehicle via the speed reducer 30. The rotary electric machine 20 includes a case 21. The case 21 includes an inlet 21a and an oil reservoir 21b, and accommodates the rotor and the stator of the rotary electric machine 20. The case 21 is provided with the inverter 10 from the outside. The inverter 10 is provided on the case 21 from the lateral direction.

The inlet 21a penetrates an upper wall of the case 21, and allows communication between inside and outside of the case 21. The oil OL serving as a cooling liquid is introduced into the case 21 through the inlet 21a. The introduced oil OL falls by an action of gravity, and is stored in the oil reservoir 21b after lubricating the rotor and cooling the stator. A part of the stator can be disposed in the oil reservoir 21b, so that the oil OL stored in the oil reservoir 21b can be used for cooling the stator.

The speed reducer 30 decelerates an input rotation from the rotary electric machine 20 and outputs the decelerated rotation. The speed reducer 30 includes a case 31. The case 31 includes an outlet 31a and an oil reservoir 31b, and accommodates a speed reduction gear mechanism. The case 31 is integrated with the case 21 by, for example, bolt fastening, and constitutes a housing 40 of the rotary electric machine 20 and the speed reducer 30 together with the case 21.

The housing 40 includes a communication port 41, and the communication port 41 allows communication between the oil reservoir 21b in the case 21 and the oil reservoir 31b in the case 31. Therefore, the oil OL can be introduced from the oil reservoir 21b to the oil reservoir 31b through the communication port 41. The wall in which the communication port 41 is provided is constituted by, for example, a part of the case 21.

The oil reservoir 31b stores the oil OL introduced from the oil reservoir 21b. The oil OL stored in the oil reservoir 31b is scooped up by a rotating member such as a gear, and is used to lubricate the speed reduction gear mechanism. The oil OL is discharged from the oil reservoir 31b inside the case 31 through the outlet 31a. The speed reducer 30 corresponds to a power transmission mechanism.

The cooling device 50 includes an oil pump 51, an oil cooler 52, and a connection path 53. The oil pump 51 includes a suction port 51a and a discharge port 51b, and pumps the oil OL. The oil cooler 52 is connected to the discharge port 51b, and the oil cooler 52 cools the oil OL pumped by the oil pump 51.

The connection path 53 is branched from the discharge port 51b of the oil pump 51 and connected to the inverter 10 and the rotary electric machine 20 via the oil cooler 52. One branch of the connection path 53 is connected to the inlet 21a of the rotary electric machine 20. The other branch of the connection path 53 is connected to one end of the partial path 53a.

The partial path 53a is a part of the connection path 53 provided in the case 11, and has both ends penetrating the case 11. One end of the partial path 53a penetrates the case 11 on a front side in FIGS. 1 and 2, and the other end penetrates the case 11 on a back side in FIGS. 1 and 2. The connection path 53 is further connected to the suction port 51a of the oil pump 51 after the other end of the partial path 53a merges with the outlet 31a of the speed reducer 30.

In this way, a first circulation path C1 and a second circulation path C2 are formed in the unit 100. The first circulation path C1 is a circulation path in which the oil OL passes from the oil pump 51 through the oil cooler 52 and the inverter 10 in this order and returns to the oil pump 51. The second circulation path C2 is a circulation path in which the oil OL passes from the oil pump 51 through the oil cooler 52, the rotary electric machine 20, and the speed reducer 30 in this order and returns to the oil pump 51. The first circulation path C1 corresponds to a liquid flow path, and the oil OL flows in the partial path 53a using the oil pump 51 incorporated in the first circulation path C1 as a cooling liquid supply source.

As shown in FIG. 2, the inverter 10 further includes a fiber body 13. The fiber body 13 is a heat conductive fiber body, and is a fiber body made of a material having heat conductivity such as metal including an alloy or carbon. The fiber body 13 is, for example, a heat conductive fiber body made of a material having a higher thermal conductivity than the mold resin 122f. The fiber body 13 is provided in the case 11, and has a plate-like or belt-like extending shape. The fiber body 13 includes a contact portion 13a and a bending portion 13b.

The contact portion 13a is provided at one end of the fiber body 13 and is in contact with the heat dissipation member 122e. The contact portion 13a is disposed between the heat dissipation member 122e and the board 121, and a surface having a plate-like shape or a belt-like shape in the contact portion 13a is in surface contact with a surface of the heat dissipation member 122e. The contact portion 13a and the heat dissipation member 122e can be bonded by beam welding or ultrasonic welding, for example. The contact portion 13a is in contact with the heat dissipation member 122e to be thermally connected to the semiconductor element 122a.

The bending portion 13b is provided at the other end of the fiber body 13. The bending portion 13b is constituted by a bent part of the fiber body 13, and is provided other than the contact portion 13a. The bending portion 13b is disposed in the partial path 53a, thereby being disposed in the first circulation path C1, that is, in the flow (liquid flow) of the oil OL in the first circulation path C1.

When the oil OL flows on a surface of the bending portion 13b, turbulence occurs. As a result, cooling of the bending portion 13b itself is promoted. The bending portion 13b is thermally connected to the semiconductor element 122a via the contact portion 13a. Therefore, by releasing heat from the semiconductor element 122a to the oil OL via the bending portion 13b, the semiconductor element 122a is cooled using an effect of the turbulence. As a result, the cooling of the semiconductor element 122a is promoted, and cooling efficiency of the semiconductor element 122a is improved. The fiber body 13 has a structure in which length and flexibility thereof can be appropriately adjusted. Therefore, a degree of layout freedom of the partial path 53a is high, which means that the partial path 53a may be formed in any place, and a degree of layout freedom of the entire unit 100 is also improved.

The bending portion 13b is bent at a plurality of positions. Therefore, a surface area of the bending portion 13b in the partial path 53a is increased as compared with a case where there is no portion bent, and larger turbulence is caused by the oil OL flowing on the surface of the bending portion 13b. As a result, the cooling of the semiconductor element 122a is further promoted. In the present embodiment, the bending portion 13b is bent in a spiral shape by bending the fiber body 13 along an extending direction of the fiber body 13 in a rounded manner. Therefore, the surface area of the bending portion 13b is increased not only in an outermost portion of the spiral shape but also in a portion inside the outermost portion.

The bending portion 13b in the partial path 53a is disposed such that the bending direction of the bending portion 13b intersects the liquid flow direction F of the oil OL passing through the bending portion 13b. Therefore, a liquid flow resistance is reduced as compared with a case where the bending direction is parallel to the liquid flow direction F. In the present embodiment, the bending direction of the bending portion 13b is substantially orthogonal to the liquid flow direction F. As a result, the liquid flow resistance is reduced as much as possible. The liquid flow direction F is an extending direction of the partial path 53a.

The partial path 53a can be provided along an arrangement direction of the plurality of semiconductor elements 122a (for example, the front-back direction of FIG. 2). Therefore, in the unit 100, by providing the fiber body 13 for each of the plurality of semiconductor elements 122a, the cooling efficiency of each of the plurality of semiconductor elements 122a can be improved.

The oil OL has an insulation property. Therefore, even when the bending portion 13b is disposed in the partial path 53a, the insulation state of the electric circuit 12 is not particularly deteriorated by the oil OL. Further, since the partial path 53a can be made of, for example, resin, an insulation property of the electric circuit 12 is also ensured. The insulation property of the electric circuit 12 may be ensured by, for example, forming a part of the partial path 53a with resin. The connection path 53 other than the partial path 53a can be made of an appropriate material such as a metal.

In the rotary electric machine 20 and the speed reducer 30, metal-based contamination such as metal pieces or metal powder is generated from a bearing or a gear, and the metal-based contamination becomes a factor that deteriorates the insulation property of the oil OL. In this regard, the unit 100 may include, for example, a filter for capturing contamination in the connection path 53 downstream of the speed reducer 30. Therefore, even when the oil OL is shared by the inverter 10, the rotary electric machine 20, and the speed reducer 30, it is possible to prevent the deterioration of the insulation state of the electric circuit 12 due to the metal-based contamination contained in the oil OL.

Next, main functions and effects of the present embodiment will be described.
(1) The unit 100 includes the oil OL, the inverter 10, and the fiber body 13. The fiber body 13 includes the contact portion 13a that is in contact with the semiconductor element 122a of the inverter 10, and the bending portion 13b that is bent. The bending portion 13b is disposed in the first circulation path C1 of the oil OL.

In the above description, the contact portion 13a that is in contact with the semiconductor element 122a is in direct contact with the heat dissipation member 122e, and therefore is in indirect contact with the semiconductor element 122a via another heat conductive member (here, the bonding member 122d and the heat dissipation member 122e). That is, the contact of the contact portion 13a includes indirect contact via another heat conductive member. The another heat conductive member may be a member having a higher thermal conductivity than the mold resin 122f.

According to such a configuration, by disposing the bending portion 13b in the first circulation path C1, the turbulence occurs, and as a result, the cooling of the bending portion 13b itself is promoted. The fiber body 13 is a heat conductive fiber body, and the bending portion 13b is thermally connected to the semiconductor element 122a via the contact portion 13a. Therefore, by releasing heat from the semiconductor element 122a to the oil OL via the bending portion 13b, it is possible to cool the semiconductor element 122a using the effect of the turbulence, and to further improve the cooling efficiency of the semiconductor element 122a.

According to such a structure of the fiber body 13, the length and flexibility thereof can be appropriately adjusted, and therefore, it means that the cooling flow passage exemplified by the partial path 53a may be formed in any position. Therefore, according to such a configuration, a degree of layout freedom of the entire unit 100 is improved. The unit 100 can improve the cooling efficiency of the inverter 10 through the cooling of the semiconductor element 122a.

(2) In the unit 100, the contact portion 13a comes into contact with the semiconductor element 122a at one end of the fiber body 13, and the bending portion 13b is bent at the other end of the fiber body 13. According to such a configuration, the fiber body 13 does not have to be longer than necessary, and the bending portion 13b is easily formed.

(3) In the unit 100, the bending portion 13b is bent at a plurality of positions. According to such a configuration, since the surface area of the bending portion 13b in the partial path 53a can be increased as compared with the case where there is no bending, larger turbulence can be generated, thereby further enhancing the cooling efficiency.

(4) In the unit 100, the bending direction of the bending portion 13b intersects the direction of the liquid flow passing through the bending portion 13b. According to such a configuration, the liquid flow resistance can be reduced as compared with the case where the bending direction is parallel to the liquid flow direction F.

Although the embodiment of the present invention has been described above, the above embodiment is merely a part of application examples of the present invention, and is not intended to limit the technical scope of the present invention to the specific configurations of the above embodiment.

For example, the contact portion 13a may be configured to be in contact with the case 11. In this case, the inverter 10 can also be cooled using the effect of the turbulence by releasing heat from the case 11 to the oil OL via the fiber body 13. In this case, for example, the partial path 53a does not need to be provided in the case 11, and therefore, the degree of layout freedom is also high, which contributes to the improvement of the degree of layout freedom of the entire unit 100.

The cooling liquid does not necessarily have to be the oil OL, and for example, a liquid having an insulation property other than the oil OL may be used as the cooling liquid.

The unit 100 may include the rotary electric machine 20 and/or the speed reducer 30, that is, include at least one of the rotary electric machine 20 and the speed reducer 30. In this case, the unit 100 can also be referred to as, for example, a motor unit (a unit including at least a motor) or a power transmission device (a device including at least a power transmission mechanism). The motor is a rotary electric machine having an electric motor function and/or a generator function (at least one of the electric motor function and the generator function). The power transmission mechanism is, for example, a gear mechanism and/or a differential gear mechanism. The device (unit) including the motor and the power transmission mechanism is included in concepts of both the motor unit and the power transmission device. On the other hand, the electric circuit unit exemplified by the inverter 10 may be a component of the unit 100 as described above, and includes an electric circuit and an accommodating body that accommodates the electric circuit.

### DESCRIPTION OF REFERENCE SIGNS

- 10: inverter (electric circuit unit)
- 11: case
- 12: electric circuit
- 121: board
- 122: circuit portion
- 122a: semiconductor element (part of electric circuit unit)
- 13: fiber body (heat conductive fiber body)
- 13a: contact portion
- 13b: bending portion
- 20: rotary electric machine
- 30: speed reducer
- 50: cooling device
- 53: connection path
- 53a: partial path
- 100: unit
- C1: first circulation path (liquid flow path)
- OL: oil (cooling liquid)

## Claims

1. A unit, comprising:
a cooling liquid;
an electric circuit unit; and
a heat conductive fiber body, wherein
the heat conductive fiber body includes a contact portion that is in contact with the electric circuit unit, and a bending portion that is bent, and
the bending portion is disposed in a liquid flow path of the cooling liquid.

2. The unit according to claim 1, wherein
the contact portion is in contact with the electric circuit unit at one end of the heat conductive fiber body, and
the bending portion is bent at the other end of the heat conductive fiber body.

3. The unit according to claim 1, wherein
the bending portion is bent at a plurality of positions.

4. The unit according to claim 1 or 3, wherein
a bending direction of the bending portion intersects a direction of a liquid flow passing through the bending portion.
